# EUROPEAN PATENT SPECIFICATION

(11) **EP 3 843 147 B1**
(45) Date of publication and mention of the grant of the patent: **12.02.2025**
(21) Application number: 19851566.0
(22) Date of filing: 31.07.2019
(51) Int. Cl.: H10K 59/80, H10K 59/121, H10K 59/12, H10K 102/00

(54) **DISPLAY PANEL, FABRICATION METHOD THEREFOR AND ELECTRONIC DEVICE THEREWITH**
ANZEIGETAFEL, HERSTELLUNGSVERFAHREN DAFÜR UND ELEKTRONISCHE VORRICHTUNG DAMIT.
PANNEAU D'AFFICHAGE, SON PROCÉDÉ DE FABRICATION ET DISPOSITIF ÉLECTRONIQUE AVEC CELUI-LÀ.

(30) Priority: 24.08.2018 CN 201810974067
(43) Date of publication of application: 30.06.2021
(73) Proprietor: VIVO MOBILE COMMUNICATION CO., LTD., Dongguan, Guangdong 523860 (CN)
(72) Inventor: WU, Chunwei, Dongguan, Guangdong 523860 (CN)
(74) Representative: Lavoix
(86) International application number: PCT/CN2019/098549
(87) International publication number: WO 2020/038200

(56) References cited:
- CN-A- 106 981 585
- CN-A- 108 074 958
- CN-A- 109 148 537
- CN-U- 207 338 380
- CN-U- 207 338 380
- KR-A- 20170 079 506
- US-A1- 2015 303 399
- US-A1- 2016 260 923
- US-A1- 2017 193 898
- US-A1- 2018 005 574
- US-A1- 2018 033 847
- US-B1- 10 084 150

## Description

### TECHNICAL FIELD

The present disclosure relates to the field of display device technologies, and in particular, to a display panel, a fabrication method, and an electronic device.

### BACKGROUND

At present, display panels are widely used in electronic devices such as mobile terminals and televisions, and become one of the most important electronic devices in people's life. People have an increasingly high requirement on display panels. A mobile terminal is used as an example, most display panels on mobile terminals in related technologies do not have light transmission. A display panel and a photosensitive device (for example, a camera) need to be disposed separately, such as a common front-facing camera is located in an upper region of the display panel, and the display panel needs to be provided with a through hole to ensure proper camera operation. However, this structure limits the display area of the display panel, and is not conducive to the development towards a higher screen-to-body ratio.

CN106 981 585 A, US 2018/005574 A1, US 2018/033847 A1 , US 2016/260923 A1 , US 2015/303399 A1 , US 2017/193898 A1 and CN 207 338 380 U disclose display devices similar to the one of the present invention.

### SUMMARY

The present invention concerns a display panel in accordance with claim 1 and a method of manufacturing a display panel in accordance with claim 5.

In the display panel provided in the embodiments of the present disclosure, a part corresponding to the first light-transmitting region and the second light-transmitting region not only can transmit light, but also has a light emitting display function. When the display panel is applied to an electronic device, a light sensitive device can be mounted in the part corresponding to the first light-transmitting region and the second light-transmitting region. Therefore, this helps flexibly dispose the light sensitive device, expands the application scope of the display panel, and better facilitates the development towards a larger display area of the display panel.

### BRIEF DESCRIPTION OF DRAWINGS

To describe the technical solutions in the embodiments of the present disclosure more clearly, the following briefly describes the accompanying drawings required in the embodiments of the present disclosure. Apparently, the accompanying drawings in the following descriptions show merely some embodiments of the present disclosure, and a person of ordinary skill in the art may still derive other accompanying drawings from these accompanying drawings without creative efforts.
FIG. 1 is a structural diagram of a display panel according to an embodiment of the present disclosure; and
FIG. 2 is a partial cutaway diagram of the display panel in FIG. 1.

### DESCRIPTION OF EMBODIMENTS

The following clearly and completely describes the technical solutions in the embodiments of the present disclosure with reference to the accompanying drawings in the embodiments of the present disclosure.

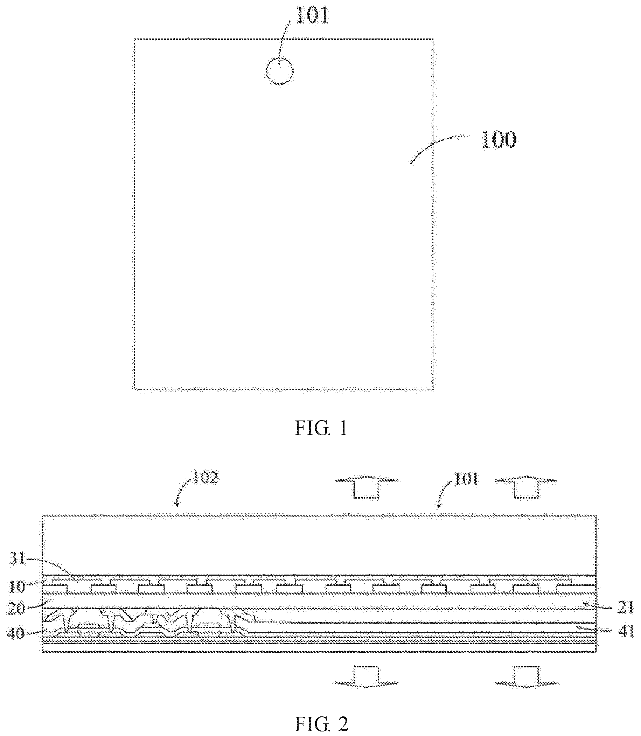

The embodiments of the present disclosure provide a display panel. Referring to FIG. 1 and FIG. 2, the display panel 100 includes a first electrode layer 10, an organic light emitting layer (not shown), a second electrode layer 20, and a drive layer 40 that are stacked sequentially. Both the first electrode layer 10 and the organic light emitting layer are light-transmitting layers, and a first light-transmitting region 21 is disposed on the second electrode layer 20. The organic light emitting layer has several pixel units 31, and each pixel unit 31 is electrically connected to the first electrode layer 10 and the second electrode layer 20. The drive layer 40 is configured to control the pixel unit 31 to emit light, the drive layer 40 has a second light-transmitting region 41, and the second light-transmitting region 41 is disposed in correspondence with the first light-transmitting region 21.

In the embodiments of the present disclosure, the first electrode layer 10 is a cathode layer, the second electrode layer 20 is an anode layer, and the pixel unit 31 can emit light when being connected to both the first electrode layer 10 and the second electrode layer 20, that is, the organic light emitting layer emits light. The first electrode layer 10 is a light-transmitting material. The first light-transmitting region 21 is disposed on the second electrode layer 20, so that a coverage region of the first light-transmitting region 21 can transmit light. In addition, the organic light emitting layer covers the first light-transmitting region 21, that is, the pixel unit 31 covers the first light-transmitting region 21, so that the pixel unit 31 can implement light emitting display above the first light-transmitting region 21. Besides, the second light-transmitting region 41 is disposed in a region that is of the drive layer 40 and that corresponds to the first light-transmitting region 21, so that a part that is of the display panel 100 and that corresponds to the first light-transmitting region 21 and the second light-transmitting region 41 not only can transmit light, but also has a light emitting display function, to conveniently mount a light sensitive device at a lower region that is on one side of the display panel 100 and that corresponds to the first light-transmitting region 21 and the second light-transmitting region 41. In this way, applicability of the display panel 100 is improved. When the display panel 100 is applied to an electronic device, the light sensitive device can be conveniently mounted in a lower region of the display panel 100. The first light-transmitting region 21 and the second light-transmitting region 41 sense light, so that the display panel 100 can develop towards a larger display area. It may be understood that a corresponding non-light-transmitting region 102 of the display panel 100 may perform a display function.

For example, when the display panel 100 is applied to a mobile terminal, a light sensitive device such as a camera or a flash may be mounted in a lower region that is of the mobile terminal and that corresponds to the first light-transmitting region 21 and the second light-transmitting region 41. In this way, the light sensitive device does not need to occupy an area of the display panel of the electronic device. This helps the display panel 100 develop towards a larger size, and improves a screen-to-body ratio of the mobile terminal.

In the embodiments of the present disclosure, the display panel 100 includes the light-transmitting region 101 corresponding to the first light-transmitting region 21 and the second light-transmitting region 41, and a non-light-transmitting region 102 that cannot transmit light other than the light-transmitting region 101. When the pixel unit 31 that is of the organic light emitting layer and that corresponds to the first light-transmitting region 21 emits light, this region may display a solid color such as red and blue or a color such as white and gray, to avoid a great difference from a color displayed in the non-light-transmitting region 102 of the display panel 100, and ensure a display effect and aesthetic beauty of the display panel 100.

In the embodiments of the present disclosure, the drive layer 40 has several drive circuits (not shown), the drive circuits are separately electrically connected to the first electrode layer 10 and the second electrode layer 20, to control the pixel unit 31 to emit light, and the drive circuits are located outside the second light-transmitting region 41. It should be noted that the drive circuit includes several non-light-transmitting elements (for example, thin film transistors). The drive circuit is disposed outside the second light-transmitting region 41, to prevent non-light-transmitting elements from interfering with light transmission of a region in the second light-transmitting region 41. The drive circuit is disposed outside the second light-transmitting region 41, that is, the drive circuit is not disposed below the second light-transmitting region 41, and the second light-transmitting region 41 not including the drive circuit is formed at a position that is of the drive layer 40 and that corresponds to the first light-transmitting region 21, to ensure that the coverage region of the second light-transmitting region 41 of the display panel has better light transmission performance.

The drive circuit includes several first drive circuits, the several first drive circuits are configured to control the pixel unit 31 within a coverage region of the first light-transmitting region 21 to emit light, and one first drive circuit controls at least two pixel units 31 located within the coverage region of the first light-transmitting region 21 to emit light simultaneously. In this way, the pixel unit 31 that is of the organic light emitting layer and that corresponds to the coverage region of the first light-transmitting region 21 is controlled by the first drive circuit. The first drive circuit and another drive circuit of the drive layer 40 may be disposed separately. The first drive circuit is disposed at an edge of the second light-transmitting region 41, and the another drive circuit of the drive layer 40 may be disposed in another region of the drive layer 40.

The first drive circuit is disposed around the edge of the second light-transmitting region 41. As shown in FIG. 2, a region other than the first light-transmitting region 21 on the second electrode layer 20 is a non-light-transmitting region, and a region other than the second light-transmitting region 41 on the drive layer 40 corresponds to the non-light-transmitting region. In this case, the first drive circuit is disposed in a coverage region of the non-light-transmitting region and does not interfere with light transmission performance of the first light-transmitting region 21. In addition, the drive circuit is disposed around the edge of the second light-transmitting region 41. For example, as shown in FIG. 1, the first drive circuit may be disposed around the circular second light-transmitting region 41, to control the pixel unit 31 located within the coverage region of the first light-transmitting region 21 to emit light.

It should be noted that because the first drive circuit is disposed, a region that is of the display panel 100 and that corresponds to the first drive circuit does not display content and is a non-display region, and may be visually black. Therefore, each first drive circuit controls at least two pixel units 31 located within the coverage region of the first light-transmitting region 21 to emit light simultaneously. Compared with setting in which one drive circuit controls one pixel unit 31 to emit light, this can reduce a quantity of first drive circuits, to reduce an area of the non-display region, and ensure that the display panel 100 can have a better display effect.

In the present invention, the second electrode layer 20 has a metal layer (not shown), and a through hole is disposed on the metal layer to form the first light-transmitting region 21. It is understood that the metal layer is made of a non-light-transmitting metal material. To implement light transmission performance of the display panel 100, the through hole is disposed on the metal layer. The through hole may be formed in an etching process. That is, the second electrode layer 20 has the metal layer provided with the through hole, so that the first light-transmitting region 21 can transmit light.

The second electrode layer 20 does include a first film layer, a metal layer, and a third film layer that are successively disposed. The first film layer and the third film layer are made of light-transmitting materials, and a through hole is disposed on the metal layer. For example, the first film layer may be an indium tin oxide (Indium Tin Oxide, ITO) material, the third film layer may also be an ITO material, and the metal layer may be a silver layer. It should be noted that the first light-transmitting region 21 may be formed at an edge of the second electrode layer 20. Alternatively, as shown in FIG. 1, the first light-transmitting region 21 may be surrounded by a non-light-transmitting region.

Optionally, at least one first light-transmitting region 21 is disposed on the second electrode layer 20, the drive layer 40 includes at least one second light-transmitting region 41, and one first light-transmitting region 21 is disposed in one-to-one correspondence with one second light-transmitting region 41. That is, the display panel 100 has at least one region that can transmit light. In this way, when the display panel 100 is applied to an electronic device, a light sensitive device can be better disposed in a lower region that is of the display panel 100 and that corresponds to the light-transmitting region 101. This can avoid centralized arrangement of the light sensitive device and facilitate mounting and arrangement of elements of the electronic device.

For example, one first light-transmitting region 21 may be disposed at each of an upper end and a lower end that are of the second electrode layer 20 and that correspond to the display panel 100. Two second light-transmitting regions 41 that are in a one-to-one correspondence with the two first light-transmitting regions 21 are disposed on the drive layer 40. When the display panel 100 is applied to an electronic device, a 2D camera may be disposed in a lower region of one light-transmitting region corresponding to the display panel 100, and a 3D camera may be disposed in a lower region of the other light-transmitting region corresponding to the display panel 100. This implements diverse functions of the electronic device and expands the application scope of the display panel 100.

Certainly, a structure of the present disclosure is not limited thereto. There may also be other quantities of first light-transmitting regions 21 and second light-transmitting regions 41 that are in a one-to-one correspondence with each other, for example, three or four. These quantities may be set by a person skilled in the art based on factors such as arrangement requirements and costs. This is not specifically limited in the present disclosure.

It should be noted that the display panel 100 provided in the embodiments of the present disclosure further includes a buffer layer, a substrate, an encapsulation layer, and the like. For details of an arrangement manner and an implementation, refer to the display panel in related technologies. Details are not described herein.

The embodiments of the present disclosure further provide an electronic device. The electronic device includes various technical solutions of the display panel provided in the foregoing embodiments, and can achieve the same technical effects. To avoid repetition, details are not described herein again. The electronic device may include at least one of a mobile phone, a tablet computer, an e-book reader, an MP3 player, an MP4 player, a digital camera, a laptop computer, a vehicle-mounted computer, a desktop computer, a set-top box, a smart TV, and a wearable device.

Optionally, the electronic device includes a light sensitive device. The light sensitive device is disposed on one side of the display panel and is adjacent to a drive layer, and the light sensitive device is within coverage regions of a first light-transmitting region and a second light-transmitting region. That is, the light sensitive device is disposed in a lower region of the display panel, and is disposed in correspondence with the light-transmitting region of the display panel, so that the light sensitive device can sense a light ray that passes through the light-transmitting region and perform a light sensing function, to ensure normal usage of the light sensitive device. In this way, the light sensitive device does not need to be mounted in an upper region of the display panel. This helps increase a size of the display panel, increases a screen-to-body ratio of the electronic device, and facilitates development towards a full screen of the mobile terminal.

The embodiments of the present disclosure further provide a fabrication method of a display panel, applied to the display panel provided in the foregoing embodiments. The fabrication method of the display panel includes: a step of forming a first light-transmitting region on a second electrode layer and a step of forming a second light-transmitting region on a drive layer corresponding to the position of the first light-transmitting region.

The step of forming the first light-transmitting region on the second electrode layer includes:
providing a through hole on a metal layer of the second electrode layer, to form the first light-transmitting region on the second electrode layer; and
the step of forming a second light-transmitting region on a drive layer corresponding to the position of the first light-transmitting region includes:
   forming the drive layer on one side of the second electrode layer, and disposing a drive circuit of the drive layer outside a coverage region of the first light-transmitting region of the drive layer, to form the second light-transmitting region at a position of the drive layer corresponding to the first light-transmitting region.

The second electrode layer is an anode layer. The second electrode layer includes a first film layer, a metal layer, and a third film layer that are successively formed. The first film layer and the third film layer are made of light-transmitting materials. For example, the first film layer may be an indium tin oxide (Indium Tin Oxide, ITO) material, the third film layer may also be an ITO material, and the metal layer may be a silver layer or another metal material. A through hole is provided on the metal layer, to form the first light-transmitting region on the second electrode layer, so that a part of region of the second electrode layer transmits light.

In the embodiments of the present disclosure, the through hole is formed on the metal layer by using an etching process. That is, a part of metal material of the non-light-transmitting metal layer is removed through etching, to form the first light-transmitting region, and a part that is not removed through etching is a non-light-transmitting region of the second electrode layer. A part of region at an edge of the metal layer may be removed through etching, to form the first light-transmitting region; or a part of region inside the metal layer may be removed through etching, to form the first light-transmitting region surrounded by a non-light-transmitting region.

Besides, a drive layer is formed on one side of the second electrode layer, and a drive circuit of the drive layer is disposed outside a coverage region of the first light-transmitting region of the drive layer, so that the second light-transmitting region that is not provided with the drive circuit and that corresponds to the first light-transmitting region is formed on the drive layer, and a light-transmitting region is formed on the display panel. When the display panel is applied to an electronic device, a light sensitive device may be mounted in a lower region that is of the display panel and that corresponds to the light-transmitting region, to expand the application scope of the display panel, and better facilitate the development towards a larger display area of the display panel.

Both the first electrode layer and the organic light emitting layer are made of light-transmitting materials, and a pixel unit is formed on the organic light emitting layer. That is, the organic light emitting layer is located between the first electrode layer and the second electrode layer. It may be understood that the first light-transmitting region is disposed on the second electrode layer, and the organic light emitting layer covers the first light-transmitting region, so that the pixel unit of the organic light emitting layer can implement light emitting display above the light-transmitting region. In this way, in the display panel fabricated by using the fabrication method provided in the embodiments of the present disclosure, a part corresponding to the first light-transmitting region not only can transmit light, but also has a light emitting display function, thereby expanding the application scope of the display panel.

It should be noted that the drive circuit of the drive layer includes several first drive circuits, the first drive circuits are configured to control the pixel unit within a coverage region of the first light-transmitting region to emit light, and one first drive circuit controls at least two pixel units located within the coverage region of the first light-transmitting region to emit light simultaneously. The several first drive circuits are all disposed outside the second light-transmitting region, and therefore do not interfere with light transmission of the first light-transmitting region and the second light-transmitting region, to ensure light transmission performance of the display panel. In addition, this can reduce the quantity of first drive circuits configured to control the pixel unit located within the coverage region of the first light-transmitting region to emit light, to reduce the area of the non-display region of the display panel that is caused because the first drive circuits are disposed.

It should be noted that the fabrication method of the display panel may further include a step of forming a buffer layer, a substrate, an encapsulation layer, and a thin film transistor. For details of a fabrication method and a deposition principle, refer to the fabrication method in related technologies. Details are not described herein.

## Claims

1. A display panel (100), comprising:
a first electrode layer (10), wherein the first electrode layer (10) is a light-transmitting layer;
a second electrode layer (20), wherein the second electrode layer (20) is disposed on one side of the first electrode layer (10), and the second electrode layer (20) comprises a first light-transmitting region (21);
an organic light emitting layer, wherein the first electrode layer (10), the organic light emitting layer, and the second electrode layer (20) are stacked sequentially, the organic light emitting layer has several pixel units (31), each of the pixel units (31) is electrically connected to the first electrode layer (10) and the second electrode layer (20), and the organic light emitting layer is a light-transmitting layer; and
a drive layer (40), wherein the drive layer (40) is disposed on a side that is of the second electrode layer (20) away from the organic light emitting layer and is configured to control the pixel units (31) to emit light, the drive layer (40) has a second light-transmitting region (41), and the second light-transmitting region (41) is disposed in correspondence with the first light-transmitting region (21);
wherein the second electrode layer (20) comprises a first film layer, a metal layer, and a third film layer that are successively disposed, each of the first film layer and the third film layer is made of a light-transmitting material, and a through hole is disposed on the metal layer to form the first light-transmitting region (21);
wherein the drive layer (40) has several drive circuits, wherein the drive circuits are separately electrically connected to the first electrode layer and the second electrode layer, to control the pixel units to emit light, wherein the drive circuit comprises several first drive circuits, the several first drive circuits are located outside the second light-transmitting region (41) and are disposed around an edge of the second light-transmitting region (41), the several first drive circuits are configured to control the pixel units (31) located within a coverage of the first light-transmitting region (21) to emit light, and each first drive circuit is configured to control at least two pixel units (31) located within the coverage region of the first light-transmitting region (21) to emit light simultaneously.

2. The display panel according to claim 1, wherein the second electrode layer (20) is provided with at least one first light-transmitting region (21), the drive layer (40) comprises at least one second light-transmitting region (41), and the at least one first light-transmitting region (21) and the at least one second light-transmitting region (41) are provided one to one.

3. An electronic device, comprising the display panel (100) according to any one of claims 1 to 2.

4. The electronic device according to claim 3, comprising a light sensitive device, wherein the light sensitive device is disposed on one side of the display panel (100) and is adjacent to the drive layer (30), and the light sensitive device is located within the coverage of the first light-transmitting region (21) and the second light-transmitting region (41).

5. A method of fabricating the display panel of any one of claims 1 to 2, comprising: a step of forming a first light-transmitting region on the second electrode layer and a step of forming a second light-transmitting region on the drive layer corresponding to the position of the first light-transmitting region;
the step of forming the first light-transmitting region on the second electrode layer comprises:
providing a through hole on the metal layer of the second electrode layer, to form the first light-transmitting region on the second electrode layer; and
the step of forming a second light-transmitting region on a drive layer corresponding to the position of the first light-transmitting region comprises:
forming the drive layer on one side of the second electrode layer, and disposing a drive circuit of the drive layer outside a region covered by the first light-transmitting region of the drive layer to form the second light-transmitting region at a position of the drive layer corresponding to the first light-transmitting region.

6. The fabrication method of the display panel according to claim 5, wherein the through hole is formed on the metal layer by using an etching process.

## Patentansprüche

1. Anzeigetafel (100), umfassend:
eine erste Elektrodenschicht (10), wobei die erste Elektrodenschicht (10) eine lichtdurchlässige Schicht ist;
eine zweite Elektrodenschicht (20), wobei die zweite Elektrodenschicht (20) auf einer Seite der ersten Elektrodenschicht (10) angeordnet ist, und die zweite Elektrodenschicht (20) eine erste lichtdurchlässige Region (21) umfasst;
eine organische lichtemittierende Schicht, wobei die erste Elektrodenschicht (10), die organische lichtemittierende Schicht und die zweite Elektrodenschicht (20) nacheinander gestapelt sind, die organische lichtemittierende Schicht mehrere Pixeleinheiten (31) aufweist, jede der Pixeleinheiten (31) elektrisch mit der ersten Elektrodenschicht (10) und der zweiten Elektrodenschicht (20) verbunden ist und die organische lichtemittierende Schicht eine lichtdurchlässige Schicht ist; und
eine Ansteuerungsschicht (40), wobei die Ansteuerungsschicht (40) auf einer von der organischen lichtemittierenden Schicht abgewandten Seite der zweiten Elektrodenschicht (20) angeordnet ist und konfiguriert ist, um die Pixeleinheiten (31) zu steuern, um Licht zu emittieren, wobei die Ansteuerungsschicht (40) eine zweite lichtdurchlässige Region (41) aufweist und die zweite lichtdurchlässige Region (41) in Übereinstimmung mit der ersten lichtdurchlässigen Region (21) angeordnet ist;
wobei die zweite Elektrodenschicht (20) eine erste Filmschicht, eine Metallschicht und eine dritte Filmschicht umfasst, die nacheinander angeordnet sind, wobei jede von der ersten Filmschicht und der dritten Filmschicht aus einem lichtdurchlässigen Material gefertigt ist und ein Durchgangsloch an der Metallschicht angeordnet ist, um die erste lichtdurchlässige Region (21) zu bilden;
wobei die Ansteuerungsschicht (40) mehrere Ansteuerungsschaltungen aufweist, wobei die Ansteuerungsschaltungen separat elektrisch mit der ersten Elektrodenschicht und der zweiten Elektrodenschicht verbunden sind, um die Pixeleinheiten zu steuern, um Licht zu emittieren, wobei die Ansteuerungsschaltung mehrere
erste Ansteuerungsschaltungen umfasst, wobei sich die mehreren ersten Ansteuerungsschaltungen außerhalb der zweiten lichtdurchlässigen Region (41) befinden und um einen Rand der zweiten lichtdurchlässigen Region (41) angeordnet sind, die mehreren ersten Treiberschaltungen konfiguriert sind, um die Pixeleinheiten (31), die sich innerhalb eines Abdeckungsbereichs der ersten lichtübertragenden Region (21) befinden, zu steuern, um Licht zu emittieren, und jede erste Ansteuerungsschaltung konfiguriert ist, um mindestens zwei Pixeleinheiten (31), die sich innerhalb des Abdeckungsbereichs der ersten lichtübertragenden Region (21) befinden, zu steuern, um gleichzeitig Licht zu emittieren.

2. Anzeigetafel nach Anspruch 1, wobei die zweite Elektrodenschicht (20) mit mindestens einer ersten lichtdurchlässigen Region (21) versehen ist, die Ansteuerungsschicht (40) mindestens eine zweite lichtdurchlässige Region (41) umfasst, und die mindestens eine erste lichtdurchlässige Region (21) und die mindestens eine zweite lichtdurchlässige Region (41) eins zu eins bereitgestellt sind.

3. Elektronische Vorrichtung, umfassend die Anzeigetafel (100) nach einem der Ansprüche 1 bis 2.

4. Elektronische Vorrichtung nach Anspruch 3, umfassend eine lichtempfindliche Vorrichtung, wobei die lichtempfindliche Vorrichtung auf einer Seite der Anzeigetafel (100) angeordnet ist und an die Ansteuerungsschicht (30) angrenzt, und die lichtempfindliche Vorrichtung innerhalb der Abdeckung der ersten lichtdurchlässigen Region (21) und der zweiten lichtdurchlässigen Region (41) angeordnet ist.

5. Verfahren zum Herstellen der Anzeigetafel nach
einem der Ansprüche 1 bis 2, umfassend: einen Schritt eines Bildens einer ersten lichtdurchlässigen Region auf der zweiten Elektrodenschicht und einen Schritt eines Bildens einer zweiten lichtdurchlässigen Region auf der Ansteuerungsschicht entsprechend der Position der ersten lichtdurchlässigen Region;
wobei der Schritt eines Bildens des ersten lichtdurchlässigen Bereichs auf der zweiten Elektrodenschicht Folgendes umfasst:
Bereitstellen eines Durchgangslochs an der Metallschicht der zweiten Elektrodenschicht, um die erste lichtdurchlässige Region auf der zweiten Elektrodenschicht zu bilden; und
wobei der Schritt eines Bildens einer zweiten lichtdurchlässigen Region auf einer Ansteuerungsschicht, die der Position der ersten lichtdurchlässigen Region entspricht, Folgendes umfasst:
Bilden der Ansteuerungsschicht auf einer Seite der zweiten Elektrodenschicht und Anordnen einer Ansteuerungsschaltung der Ansteuerungsschicht außerhalb einer Region, die vom ersten lichtdurchlässigen Bereich der Ansteuerungsschicht abgedeckt ist, um die zweite lichtdurchlässige Region an einer Position der Ansteuerungsschicht zu bilden, die der ersten lichtdurchlässigen Region entspricht.

6. Verfahren zum Herstellen der Anzeigetafel nach Anspruch 5, wobei das Durchgangsloch durch einen Ätzprozess an der Metallschicht gebildet ist.

## Revendications

1. Panneau d'affichage (100) comprenant :
une première couche d'électrode (10), dans lequel la première couche d'électrode (10) est une couche de transmission de la lumière ;
une deuxième couche d'électrode (20), dans lequel la deuxième couche d'électrode (20) est disposée sur un côté de la première couche d'électrode (10), et la deuxième couche d'électrode (20) comprend une première zone de transmission de la lumière (21) ;
une couche organique luminescente, dans lequel la première couche d'électrode (10), la couche organique luminescente et la deuxième couche d'électrode (20) sont empilées séquentiellement, la couche organique luminescente comporte plusieurs unités de pixels (31), chacune des unités de pixels (31) est connectée électriquement à la première couche d'électrode (10) et à la deuxième couche d'électrode (20), et la couche organique luminescente est une couche luminescente ; et
une couche d'entraînement (40), dans lequel la couche d'entraînement (40) est disposée sur un côté de la deuxième couche d'électrode (20) éloignée de la couche organique luminescente et est configurée pour commander les unités de pixels (31) afin qu'elles émettent de la lumière, la couche d'entraînement (40) comporte une deuxième région luminescente (41), et la deuxième région luminescente (41) est disposée au niveau de la première région luminescente (21) ;
dans lequel la deuxième couche d'électrode (20) comprend une première couche de film, une couche métallique et une troisième couche de film disposées successivement, chacune de la première couche de film et de la troisième couche de film étant constituées chacune d'un matériau transmettant la lumière, et un trou traversant étant disposé sur la couche métallique pour former la première région transmettant la lumière (21) ;
dans lequel la couche d'entraînement (40) comporte plusieurs circuits d'entraînement, les circuits d'entraînement étant reliés électriquement séparément à la première couche d'électrode et à la deuxième couche d'électrode, afin de commander les unités de pixels pour qu'elles émettent de la lumière, le circuit d'entraînement comportant plusieurs
premiers circuits d'entraînement, les plusieurs premiers circuits d'entraînement étant situés à l'extérieur de la deuxième région de transmission de la lumière (41) et disposés autour d'un bord de la deuxième région de transmission de la lumière (41), les plusieurs premiers circuits d'entraînement sont configurés pour commander les unités de pixels (31) situées dans la zone de couverture de la première région de transmission de la lumière (21) afin d'émettre de la lumière, et chaque premier circuit d'entraînement est configuré pour commander au moins deux unités de pixels (31) situées dans la zone de couverture de la première région de transmission de la lumière (21) afin d'émettre de la lumière simultanément.

2. Panneau d'affichage selon la revendication 1, dans lequel la deuxième couche d'électrode (20) est pourvue d'au moins une première région de transmission de la lumière (21), la couche d'entraînement (40) comprend au moins une deuxième région de transmission de la lumière (41), et l'au moins une première région de transmission de la lumière (21) et l'au moins une deuxième région de transmission de la lumière (41) sont fournies l'une à l'autre.

3. Dispositif électronique comprenant le panneau d'affichage (100) selon l'une quelconque des revendications 1 à 2.

4. Dispositif électronique selon la revendication 3, comprenant un dispositif sensible à la lumière, dans lequel le dispositif sensible à la lumière est disposé sur un côté du panneau d'affichage (100) et est adjacent à la couche d'entraînement (30), et le dispositif sensible à la lumière est situé dans la couverture de la première région de transmission de la lumière (21) et de la deuxième région de transmission de la lumière (41).

5. Procédé de fabrication du panneau d'affichage selon
l'une quelconque des revendications 1 à 2, comprenant : une étape de formation d'une première région de transmission de la lumière sur la deuxième couche d'électrode et une étape de formation d'une deuxième région de transmission de la lumière sur la couche d'entraînement correspondant à la position de la première région de transmission de la lumière ;
l'étape consistant à former la première région de transmission de la lumière sur la deuxième couche d'électrode comprend :
la création d'un trou traversant sur la couche métallique de la deuxième couche d'électrode, pour former la première région de transmission de la lumière sur la deuxième couche d'électrode ; et
l'étape consistant à former une deuxième région de transmission de la lumière sur une couche d'entraînement correspondant à la position de la première région de transmission de la lumière comprend :
la formation de la couche d'entraînement sur un côté de la deuxième couche d'électrode, et la disposition d'un circuit d'entraînement de la couche d'entraînement à l'extérieur d'une région couverte par la première région de transmission de la lumière de la couche d'entraînement pour former la deuxième région de transmission de la lumière dans une position de la couche d'entraînement correspondant à la première région de transmission de la lumière.

6. Procédé de fabrication du panneau d'affichage selon la revendication 5, dans lequel le trou traversant est formé sur la couche métallique à l'aide d'un procédé de gravure.
